(19) Europäisches Patentamt
European Patent Office
Office européen des brevets

(11) **EP 2 449 682 B1**

(12) **EUROPÄISCHE PATENTSCHRIFT**

(45) Veröffentlichungstag und Bekanntmachung des Hinweises auf die Patenterteilung:
**09.05.2018 Patentblatt 2018/19**

(21) Anmeldenummer: **10732856.9**

(22) Anmeldetag: **30.06.2010**

(51) Int Cl.:
*G10L 19/00* (2013.01)  *H03M 7/30* (2006.01)

(86) Internationale Anmeldenummer:
**PCT/EP2010/003969**

(87) Internationale Veröffentlichungsnummer:
**WO 2011/000567 (06.01.2011 Gazette 2011/01)**

(54) **VERFAHREN ZUR VEKTOR-QUANTISIERUNG EINES MERKMALSVEKTORS**

METHOD FOR VECTOR QUANTIZATION OF A FEATURE VECTOR

PROCÉDÉ DE QUANTIFICATION VECTORIELLE D UN VECTEUR CARACTÉRISTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **02.07.2009 EP 09008685**

(43) Veröffentlichungstag der Anmeldung:
**09.05.2012 Patentblatt 2012/19**

(73) Patentinhaber: **Unify GmbH & Co. KG**
**80807 München (DE)**

(72) Erfinder:
• **SCHANDL, Stefan**
**A-1130 Wien (AT)**
• **SETIAWAN, Panji**
**91054 Erlangen (DE)**

(74) Vertreter: **Fritzsche, Thomas**
**Fritzsche Patent**
**Naupliastraße 110**
**81545 München (DE)**

(56) Entgegenhaltungen:
• **ORCHARD M T ED - INSTITUTE OF ELECTRICAL AND ELECTRONICS ENGINEERS: "A fast nearest-neighbor search algorithm" SPEECH PROCESSING 1. TORONTO, MAY 14 - 17, 1991; [INTERNATIONAL CONFERENCE ON ACOUSTICS, SPEECH & SIGNAL PROCESSING. ICASSP], NEW YORK, IEEE, US LNKD-DOI:10.1109/ICASSP.1991.150755, Bd. CONF. 16, 14. April 1991 (1991-04-14), Seiten 2297-2300, XP010043441 ISBN: 978-0-7803-0003-3**
• **VIDAL RUIZ E: "An algorithm for finding nearest neighbours in (approximately) constant average time" PATTERN RECOGNITION LETTERS NETHERLANDS, Bd. 4, Nr. 3, Juli 1986 (1986-07), Seiten 145-157, XP002603090 ISSN: 0167-8655**
• **Clarkson, Kenneth L.: "Nearest-Neighbor Searching and Metric Space Dimensions" 23. Oktober 2005 (2005-10-23), Seiten 1-45, XP002603091 Gefunden im Internet: URL:http://www.almaden.ibm.com/u/kclarkson /nn_survey/p.pdf [gefunden am 2010-10-01]**
• **Ye Lexiang, Wang Xiaoyue, Keogh Eamonn, Mafra-Neto Agenor: "Autocannibalistic and Anyspace Indexing Algorithms with Applications to Sensor Data Mining" Proceedings of the SIAM International Conference on Data Mining, SDM 2009, 30.40.-02.05.2009 2. Mai 2009 (2009-05-02), Seiten 85-96, XP002603093 Gefunden im Internet: URL:http://www.siam.org/proceedings/datami ning/2009/dm09_009_yel.pdf [gefunden am 2010-10-01]**

**Beschreibung**

Die Erfindung betrifft ein Verfahren zur Vektor-Quantisierung eines Merkmalsvektors, insbesondere im Zusammenhang mit einer Datenkompression eines zu übertragenden oder eines zu speichernden Signals, insbesondere eines Sprachsignals oder eines Videosignals, bei dem wenigstens ein Codebuch, bestehend aus einer Mehrzahl von Codebuchvektoren, nach einem den Merkmalsvektor repräsentierenden Codevektor durchsucht wird, indem während der Suche eine Folge von Codebuchvektoren auf ihre Eignung zur Repräsentation des Merkmalsvektors geprüft wird.

Derartige Verfahren eignen sich zur Repräsentation, das heißt insbesondere zur Kodierung, mehrdimensionaler Merkmalsvektoren, deren Vektorkomponenten einem häufig großen Bereich möglicher Werte entstammen, durch eine vergleichsweise kleine Zahl von Codebuchvektoren bzw. durch die Indizes dieser Codebuchvektoren, welche diese Codebuchvektoren eindeutig kennzeichnen. Solche Verfahren werden im Zusammenhang mit einer Vielzahl von gebräuchlichen Kodierungsverfahren insbesondere im Bereich der Sprach-, Bild- oder Videokodierung, aber auch zur Kodierung anderer Signale eingesetzt, insbesondere um die Menge der zu übertragenden oder zu speichernden Daten zu reduzieren (Datenkompression).

Die Reduktion der Datenmenge erfolgt dabei unter anderem durch die Ersetzung einer Menge unterschiedlicher Merkmalsvektoren durch den gleichen Codevektor, welcher alle diese unterschiedlichen Merkmalsvektoren repräsentiert. Damit ist wegen der Unterschiede zwischen diesen Merkmalsvektoren ein Kodierungsfehler verbunden, der umso größer ist, je größer der Abstand zwischen dem zu kodierenden Merkmalsvektor und dem ihn repräsentieren Codevektor ist. Der Abstand zwischen Vektoren wird dabei mit Hilfe eines durch die Anwendung definierten Abstandsmaßes gemessen, das die mathematischen Eigenschaften einer Metrik oder einer Norm erfüllen sollte.

Zu jedem Codebuchvektor eines Codebuches gehört somit eine diesen Codebuchvektor umgebende Zelle im Raum der Merkmalsvektoren, welche alle diejenigen Merkmalsvektoren enthält, die durch den Codebuchvektor dieser Zelle repräsentiert werden. Diese Zelle entspricht der Menge aller Codebuchvektoren, welche keinem anderen Codebuchvektor des Codebuches im Sinne des gewählten Abstandsmaßes näher liegen als dem Codebuchvektor, der von dieser Zelle umgeben wird. Die Form der Zelle hängt folglich von dem gewählten Abstandsmaß und von der Verteilung der Codebuchvektoren im Raum der Merkmalsvektoren ab.

Die mit solchen Verfahren verbundenen Informationsverluste sind umso kleiner, je größer die Anzahl der Codebuchvektoren ist und je dichter diese Codebuchvektoren im Raum der Merkmalsvektoren platziert sind. Dabei müssen die Codebuchvektoren nicht gleichmäßig im Raum der Merkmalsvektoren verteilt sein, sondern es kann eine Konzentration von Codebuchvektoren in solchen Gebieten des Raumes der Merkmalsvektoren zweckmäßig sein, in denen eine besondere Genauigkeit der Repräsentation erforderlich oder wünschenswert ist. Mit der Anzahl der Codebuchvektoren und ihrer Dichte im Raum der Merkmalsvektoren steigt andererseits jedoch auch der Aufwand für die Ermittlung eines optimalen Codevektors oder auch nur eines näherungsweise optimalen Codevektors, welcher den zu kodierenden Merkmalsvektor am besten oder mit vertretbarem Fehler repräsentiert.

Der vorliegenden Erfindung liegt die Aufgabe zugrunde, ein Verfahren zur Vektor-Quantisierung eines Merkmalsvektors anzugeben, welches (im Vergleich zu bekannten Verfahren) eine möglichst hohe (Steigerung der) Genauigkeit mit einem möglichst geringen (Zuwachs an) Aufwand verbindet. Diese Aufgabe wird durch ein Verfahren zur Vektor-Quantisierung mit Merkmalen nach dem Patentanspruch 1 gelöst.

Bei diesem erfindungsgemäßen Verfahren wird wenigstens ein Codebuch, welches eine Mehrzahl von Codebuchvektoren umfasst, nach einem den Merkmalsvektor repräsentierenden Codevektor durchsucht, indem während der Suche eine Folge von Codebuchvektoren auf ihre Eignung zur Repräsentation des Merkmalsvektors geprüft wird. Im Verlauf oder vorzugsweise vor Beginn dieser Suche wird zu wenigstens einem zu prüfenden Codebuchvektor ein Satz von Nachbarvektoren bestimmt, und die Suche nach dem Codevektor wird auf alle Nachbarvektoren oder auf eine Teilmenge der Nachbarvektoren erstreckt.

Im Zusammenhang mit der Beschreibung der vorliegenden Erfindung soll in Übereinstimmung mit dem üblichen Sprachgebrauch unter einem Codevektor, der einen Merkmalsvektor repräsentiert ein Codebuchvektor verstanden werden, der im Rahmen einer Suche im Codebuch als derjenige Codebuchvektor ermittelt wurde, der unter den auf ihre Eignung zur Repräsentation des Merkmalsvektors geprüften Codebuchvektoren dem Merkmalsvektor ähnlicher ist als jeder andere geprüfte Codebuchvektor, oder für den wenigstens gilt, das keiner der geprüften Codebuchvektoren dem Merkmalsvektor ähnlicher ist als dieser Codevektor. Zwei Vektoren sind sich dabei umso ähnlicher, je geringer ihr Abstand im Sinne eines gewählten Abstandsmaßes ist.

Sofern die Suche nach geeigneten Codebuchvektoren nicht erschöpfend ist in dem Sinne, dass das gesamte Codebuch vollständig durchsucht wird und alle Codebuchvektoren auf ihre Eignung geprüft werden, kann es selbstverständlich grundsätzlich einen oder mehrere nicht geprüfte Codebuchvektoren im Codebuch geben, die dem Merkmalsvektor ähnlicher sind.

Da das Codebuch aus einer abzählbaren, ja sogar endlichen Menge von Codebuchvektoren besteht, können die Codebuchvektoren abgezählt, also zweckmäßig durch einen Index, den Codebuchvektorindex, eindeutig charakterisiert werden. Zwischen den Codebuchvektoren und den Codebuchvektorindices besteht eine eineindeutige Beziehung, weshalb man die Begriffe Codebuchvektor und Codebuchvektorindex synonym verwenden kann, wovon im Rahmen der vorliegenden Beschreibung stellenweise Gebrauch gemacht wird, weil es dem üblichen Sprachgebrauch des Fachmannes entspricht.

Der Satz von Nachbarvektoren eines Codebuchvektors enthält vorzugsweise eine Menge von Codebuchvektoren, welche dem Codebuchvektor, zu dem dieser Satz gehört, im Sinne eines Abstandsmaßes im Raum der Codebuchvektoren am nächsten gelegen sind, also die geringsten Abstände zu diesem Codebuchvektor aufweisen. Als Abstandsmaß im Raum der Codebuchvektoren eignet sich dabei jedes Abstandsmaß mit den Eigenschaften einer Metrik, insbesondere das euklidische Abstandsmaß.

Durch die Erstreckung der Suche nach dem Codevektor, welcher den Merkmalsvektor repräsentieren soll, auf wenigstens eine Teilmenge der Nachbarvektoren, soll vorzugsweise erreicht werden, dass in der Nachbarschaft eines Codevektors nicht andere Codebuchvektoren übersehen werden, welche den zu kodierenden Merkmalsvektor besser repräsentieren könnten. Dabei repräsentiert ein erster Codebuchvektor einen Merkmalsvektor dann besser als ein zweiter Codebuchvektor, wenn dieser erste Codebuchvektor ein geringeres Abstandsmaß zu dem Merkmalsvektor aufweist als der zweite Codebuchvektor. Der Satz von Nachbarvektoren ("next-neighbour array") wird zu einem Codebuchvektor mit Hilfe einer Nachbarvektortabelle ("next-neighbour table") ermittelt, die jedem Codebuchvektor aus einer Mehrzahl von Codebuchvektoren des wenigstens einen Codebuchs eine Anzahl nächster Nachbarvektoren zuordnet. Bei dieser Zuordnung wird, ausgehend von dem Codebuchvektor, dessen Satz von Nachbarvektoren bestimmt werden soll und welcher als Startvektor in den Satz der Nachbarvektoren eingetragen wird, die Folge der jeweils nächsten Nachbarvektoren eines jeden bereits vorhandenen Eintrags im Satz der Nachbarvektoren ihrerseits in den Satz der Nachbarvektoren eingetragen. Dies geschieht vorzugsweise so lange, bis keine neuen Einträge mehr hinzukommen, oder bis die Eintragung abgebrochen wird, beispielsweise weil die Zahl der Nachbarvektoren im Satz der Nachbarvektoren eine vorgegebene Grenze erreicht hat oder überschritten hat. Die Nachbarvektortabelle zu einem Codebuchvektor wird ermittelt, indem zunächst zu wenigstens einer Teilmenge der Codebuchvektoren des wenigstens einen Codebuchs eine Anzahl nächster Nachbarvektoren, vorzugsweise durch Bestimmung der jeweiligen Abstände ermittelt wird, und indem die so gewonnene Nachbarvektortabelle ("max-next-neighbour table") durch eine Iteration folgender Schritte (die man dem fachmännischen Sprachgebrauch folgend auch als "pruning" bezeichnen kann) modifiziert wird:

- Zu einem Codebuchvektor in der Nachbarvektortabelle werden dessen zwei nächste Nachbarvektoren ermittelt; sie bilden die Elternvektoren dieses Codebuchvektors;
- zu dem ersten Elternvektor werden die zwei nächsten Nachbarvektoren aus der Nachbarvektortabelle ermittelt; sie bilden die Kindervektoren des ersten Elternvektors;
- der zweite Elternvektor wird aus der Nachbarvektortabelle gestrichen und durch seinen nächsten Nachbarvektor in der Nachbarvektorentabelle ersetzt, falls einer der beiden Kindervektoren des ersten Elternvektors mit dem zweiten Elternvektor übereinstimmt;
- zu dem zweiten Elternvektor werden die zwei nächsten Nachbarvektoren aus der Nachbarvektorentabelle ermittelt; sie bilden die Kindervektoren des zweiten Elternvektors;
- der erste Elternvektor wird aus der Nachbarvektorentabelle gestrichen und durch seinen nächsten Nachbarvektor in der Nachbarvektorentabelle ersetzt, falls einer der beiden Kindervektoren des zweiten Elternvektors mit dem ersten Elternvektor übereinstimmt.

Auf diese Weise soll eine Nachbarvektorentabelle, in der einige oder alle Nachbarvektoren gegenseitig aufeinander verweisen, vermieden werden.

Besonders bevorzugt ist die Verwendung eines Verfahrens nach einem der beschriebenen Ausführungsbeispiele zur Verringerung eines Maßes für den Kodierungsfehler im Zusammenhang mit einem Verfahren zur Sprachkodierung oder zur Videokodierung. Dabei schließt sich die Erstreckung der Suche auf die Nachbarvektoren vorzugsweise an eine Suche nach einem Standard-Verfahren an. Dazu wird vorzugsweise zu dem mit dem Standard-Verfahren gefundenen Codevektor ein Satz von Nachbarvektoren erstellt, auf den die Suche nach einem optimalen oder beinahe optimalen Codevektor dann erstreckt wird. Dies geschieht vorzugsweise vor Beginn der Suche für alle Codebuchvektoren oder für eine Teilmenge der Codebuchvektoren, weil hierdurch die Suche bedeutend beschleunigt werden kann. Die Konstruktion des next-neighbour arrays und überhaupt alle Operationen, die nur von den Codebuchelementen, nicht jedoch von einem aktuell zu codierenden Vektor abhängen, sind nicht Teil der Suche im Codebuch, sondern sind Teil der Konstruktionen dieses speziellen Codebuches oder seiner Vorbereitung im Sinne einer beschleunigten und/oder verbesserten Suche. Somit werden diese Operationen, die nur von den Codebuchelementen, nicht jedoch von einem aktuell zu codierenden Vektor abhängen, vorzugsweise nicht während der Suche also während der Codierung ausgeführt, sondern werden vorteilhaft schon zuvor (der Fachmann sagt: "off-line") berechnet.

Im Folgenden wird die Erfindung anhand bevorzugter Ausführungsbeispiele und mit Hilfe von Figuren näher beschrieben. Dabei zeigt

FIG. 1 in schematischer Weise die Erzeugung eines Satzes von Nachbarvektoren zu einem Codebuchvektor mit Hilfe einer Nachbarvektortabelle;

FIG. 2 in schematischer Weise den Ablauf der Elimination von überflüssigen Einträgen in der Nachbarvektorentabelle.

Das erfindungsgemäße Verfahren und die bevorzugten Ausführungsbeispiele lassen sich zweckmäßig am Beispiel eines Breitband- ("wideband", WB) Sprachcodec nach dem G.711-Standard darstellen, weil dieser Standard den verbreiteten Standard G.711 als Schmalband-Kern ("narrowband core") enthält. Die Breitband-Erweiterung G.711.1 des G.711-Standards verwendet einen breitbandigen MDCT-Codec (MDCT = Modifizierte Diskrete CosinusTransformation), um Signalkomponenten im Frequenzbereich zwischen vier und sieben kHz zu kodieren. Einzelheiten dazu sind beispielsweise der Veröffentlichung "G.711.1: A Wideband Extension to ITU-T G.711", Y. Hiwasaki, et al., G.711.1_1569104469.pdf, zu entnehmen.

In dieser Erweiterung des G.711-Standards werden die breitbandigeren Signalkomponenten durch die Berechnung von 36 gewichteten und normalisierten Koeffizienten im MDCT-Bereich kodiert und anschließend als sechs Vektoren der Dimension 6 kodiert. Entsprechend dem Standardverfahren des G.711.1-Standards muss dabei der Merkmalsvektor durch eine Linearkombination von zwei Vektoren dargestellt werden, die zwei Codebüchern mit jeweils 32 Codebuchvektoren entstammen.

Um den Aufwand bei der Suche nach einem geeigneten Codebuchvektor vertretbar zu halten, wird dabei häufig keine erschöpfende Suche nach einem Codebuchvektor durchgeführt. Als Konsequenz davon sind die Codevektorindizes, die durch diese Standardprozedur gefunden werden, nicht immer optimal und können daher verbessert werden. Gemäß der vorliegenden Erfindung wird diese Verbesserung vorzugsweise dadurch erreicht, dass sich an die Suche nach dem Standardverfahren eine verfeinerte Suche gemäß der vorliegenden Erfindung anschließt, bei der zu dem im Standardverfahren gefundenen Codevektor ein Satz von Nachbarvektoren ermittelt wird, und bei dem die Suche auf diesen Satz von Nachbarvektoren oder auf eine Teilmenge dieses Satzes erstreckt wird.

Es ist ein Vorteil des erfindungsgemäßen Verfahrens in dieser Ausführungsform und in anderen Ausführungsformen, dass dabei unverändert die gleichen Ressourcen, nämlich das gleiche Codebuch und die gleichen Kriterien (beispielsweise der sogenannte "gain") verwendet werden, und dass die Parameter in der gleichen Form kodiert werden, wie bei dem Standardverfahren, so dass zur verbesserten Kodierung kein höherer Datenübertragungs- oder Datenspeicheraufwand erforderlich ist, weshalb auch bildhaft von einem "Null-Bit Enhancement Layer" gesprochen werden kann, da für diese Verbesserung keine Extrabits zur Kodierung erforderlich sind.

Ein weiterer Vorteil des erfindungsgemäßen Verfahrens kann darin gesehen werden, dass durch eine geeignete Wahl der Größe NN_NB des Satzes von Nachbarvektoren der zusätzliche Aufwand und die damit gewonnene zusätzliche Genauigkeit leicht gesteuert werden kann. Experimentelle Untersuchungen haben ergeben, dass verbesserte oder optimale Codevektoren sich sehr häufig in der unmittelbaren Nachbarschaft von Codevektoren befinden, die nach dem Standardverfahren bestimmt wurden. Diese Erkenntnis wird durch das erfindungsgemäße Verfahren in sehr wirkungsvoller Weise zur Verbesserung der Genauigkeit bei verhältnismäßig geringer Aufwandssteigerung genutzt.

Nach dem G.711.1-Standard wird der zu kodierende Merkmalsvektor $\mathbf{S}'_{HB}(v)$ durch das arithmetische Mittel

$$\mathbf{V}(i_0, i_1, v) = \frac{\pm \mathbf{C}_{H0w}(i_0(v)) \pm \mathbf{C}_{H1w}(i_1(v))}{2}$$

zweier Vektoren approximiert (also angenähert), die zwei Codebüchern $\mathbf{C}_{H0w}$ und $\mathbf{C}_{H1w}$ der Codebuchgröße CB_SIZE = 32 entstammen. Jedes dieser Codebücher enthält also 32 Vektoren. Hierdurch erhält man insgesamt CB_DIM = 4x32x32 = 4096 Codevektoren. Eine erschöpfende Suche innerhalb eines solchen Codebuchs ist im Zusammenhang mit Sprach- oder Videocodern eine aufwändige Rechenaufgabe, weshalb bei den Standardverfahren suboptimale Codebuchsuchen implementiert werden, um den Aufwand in vertretbarem Umfang zu halten.

Im Ergebnis werden auf diese Weise im Standardverfahren nur 49% der Merkmalsvektoren durch einen optimalen Codevektor repräsentiert. Im Zentrum des erfindungsgemäßen Verfahrens steht ein Satz von Nachbarvektoren, der zu einem Codebuchvektor mit Hilfe des Codebuchs erstellt wird. Dieser Satz ordnet im Wesentlichen einem Codebuchvektor die Indizes seiner beiden nächsten Nachbarvektoren zu. Die Anzahl NB_NN der nächsten Nachbarvektoren kann dabei begrenzt werden, um den mit dem erfindungsgemäßen Verfahren verbundenen Zusatzaufwand zu begrenzen.

Weitere Rechenvorteile können im Sinne einer Aufwandsbegrenzung genutzt werden. So enthält ein Codebuch, weil der Raum der Merkmalsvektoren ein Vektorraum (ein "linearer" Raum) im mathematischen Sinne ist (zumindest, sofern die Komponenten der Merkmalsvektoren einem "Körper" im mathematischen Sinne entstammen), zweckmäßig zu jedem Codebuchvektor CV auch dessen (vektor-additives) inverses Element -CV. Die Anzahl der Vektoren bzw.

Indices in den im Zusammenhang mit dem erfindungsgemäßen Verfahren verwendeten Tabellen (Satz der Nachbarvektoren, Nachbarvektorentabelle, etc.) kann daher häufig durch Ausnutzung entsprechender Symmetrien reduziert werden, beispielsweise auf die Hälfte (CB_DIM_H = 2048) durch eine rechnerisch geschickte Berücksichtigung des Vorzeichens von Vektoren. Dabei ist es jedoch nützlich zu beachten, dass die tatsächliche Zahl der Codebuchvektoren größer, in unserem Beispiel CB_DIM = 4096 ist.

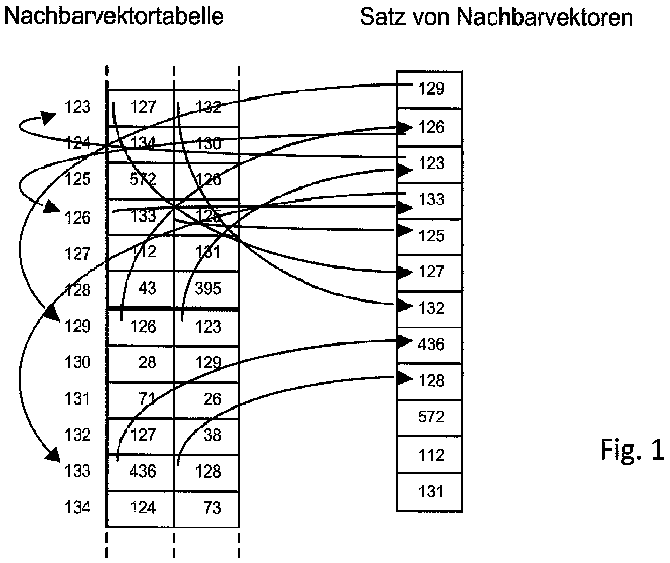

Die Prozedur zur Erzeugung des Satzes von Nachbarvektoren kann am Beispiel der FIG. 1 beschrieben werden. Bei diesem Beispiel wird zunächst davon ausgegangen, dass eine Nachbarvektorentabelle vorliegt, und dass ein vorläufig optimaler Codevektor nach einem Standardverfahren bestimmt wurde. Der Vektorindex dieses vorläufig besten Codevektors wird dann als Startwert in den Satz von Nachbarvektoren eingetragen.

In dem in FIG. 1 gezeigten Beispiel ist es der Index 129. Die beiden Indizes in der Nachbarvektorentabelle, die zu diesem Startindex gehören, werden dann ebenfalls in den Satz von Nachbarvektoren eingetragen. In dem in FIG. 1 gezeigten Beispiel handelt es sich um die Indizes 126 und 123, da diese Indizes die nächsten Nachbarvektoren gemäß der Nachbarvektorentabelle in FIG. 1 sind. Diese Vorgehensweise wird dann für jeden Index wiederholt, der in den Satz von Nachbarvektoren eingetragen wurde, wobei dafür gesorgt wird, dass derselbe Index nicht zweimal in den Satz von Nachbarvektoren eingetragen wird. In dem in der FIG. 1 gezeigten Beispiel würde dies beispielsweise für den Index 125 geschehen, dessen nächste Nachbarn nach der Nachbarvektorentabelle die Indizes 572 bzw. 126 haben, wobei jedoch der Index 126 bereits in den Satz von Nachbarvektoren aufgenommen wurde.

Die Prozedur wird beendet, wenn kein weiterer Index mehr gefunden werden kann oder wenn die vorgegebene Anzahl von Nachbarvektoren im Satz der Nachbarvektoren erreicht wurde und in den Satz von Nachbarvektoren eingetragen wurde. Daraufhin wird die Suche nach einem optimalen oder näherungsweise optimalen Codevektor für den zu kodierenden Merkmalsvektor vorzugsweise auf den gesamten Satz von Nachbarvektoren oder auf eine Teilmenge dieses Satzes ausgedehnt und der bei dieser Suche gefundene optimale oder näherungsweise optimale Codebuchvektor wird als verbesserter Codevektor zur Repräsentation des Merkmalsvektors verwendet.

Wie aus dem hier beschriebenen Ausführungsbeispiel leicht ersichtlich ist, kann durch das erfindungsgemäße Verfahren eine erschöpfende Suche im Codebuch vermieden werden; es kann jedoch eine bedeutsame Verbesserung der Genauigkeit der Codierung durch Auffindung eines verbesserten Codevektors erreicht werden. Durch die in der FIG. 1 gezeigte spezielle Struktur der Nachbarvektorentabelle wird nur eine Tabellengröße von 2x2048 anstelle von NB_NN * 2048 benötigt, wodurch Speicherplatz gespart werden kann.

Die Tabelle der Nachbarvektoren (Nachbarvektorentabelle) wird vorzugsweise durch Bearbeitung einer maximalen Nachbarvektorentabelle ("max-next-neighbour table") gewonnen, welche die maximale Anzahl nächster Nachbarn enthält und vorzugsweise durch eine Ausdünnungs-Prozedur reduziert wird. Diese Prozedur zur Ausdünnung oder Beschneidung ("pruning") der Nachbarvektorentabelle wird vorzugsweise im Zusammenhang mit dem erfindungsgemäßen Verfahren verwendet, um Situationen zu vermeiden, in denen alle oder viele Nachbarvektoren gegenseitig aufeinander verweisen.

Die Größe der anfänglichen Nachbarvektorentabelle (vor dem "pruning") beträgt vorzugsweise CB_DIM_H * MAX_NBR_NN, wobei * das Produkt und MAX_NBR_NN die vorgegebene Anzahl der nächsten Nachbarn bezeichnet. Diese Zahl ist umso größer, je größer der maximale Abstand zwischen dem Codebuchvektor, dessen nächste Nachbarn die Tabelle enthält, und einem nächsten Nachbarn dieses Codebuchvektors sein soll. Ohne eine Vorgabe einer solchen Grenze wären nämlich alle Codebuchvektoren des Codebuchs nächste Nachbarn aller Codebuchvektoren, was nicht sinnvoll wäre.

In einem ersten Schritt werden diejenigen Codebuchvektoren, deren Nachbarvektoren in der Nachbarvektorentabelle enthalten sein sollen, in eine Spalte der Nachbarvektorentabelle eingetragen. Für jeden dieser Codebuchvektoren wird der Abstand zu allen anderen Codebuchvektoren berechnet und eine vorgegebene Anzahl von nächsten Nachbarvektoren wird in der Nachbarvektorentabelle jedem Codebuchvektor zugeordnet und in die Tabelle eingetragen. Dabei werden diese Einträge vorzugsweise aufsteigend nach dem Abstandsmaß sortiert.

In einem zweiten Schritt kann die Ausdünnungsprozedur für jeden der Codebuchvektoren durchgeführt werden. Diese Prozedur untersucht die ersten beiden nächsten Nachbarvektoren ("nearest code vector") eines einzelnen Eintrages ("main code vector") für einen Codebuchvektor in der Nachbarvektortabelle. Diese beiden Indizes der nächsten Nachbarvektoren dieses Codebuchvektors werden als Elternindizes gekennzeichnet. Für den ersten Elternindex werden weitere zwei nächste Nachbarcodebuchvektoren bzw. deren Indizes aus der Tabelle bestimmt, indem der Elternindex einfach als Hauptindex ("main code vector") in der Nachbarvektorentabelle verwendet wird. Diese beiden Indizes, die so gefunden werden, werden als Kinderindizes bezeichnet.

Falls auch nur einer der beiden Kinderindizes, die auf diese Weise anhand des ersten Elternindex bestimmt wurden, mit dem zweiten Elternindex übereinstimmen, wird der zweite Elternindex aus der Nachbarvektorentabelle gelöscht.

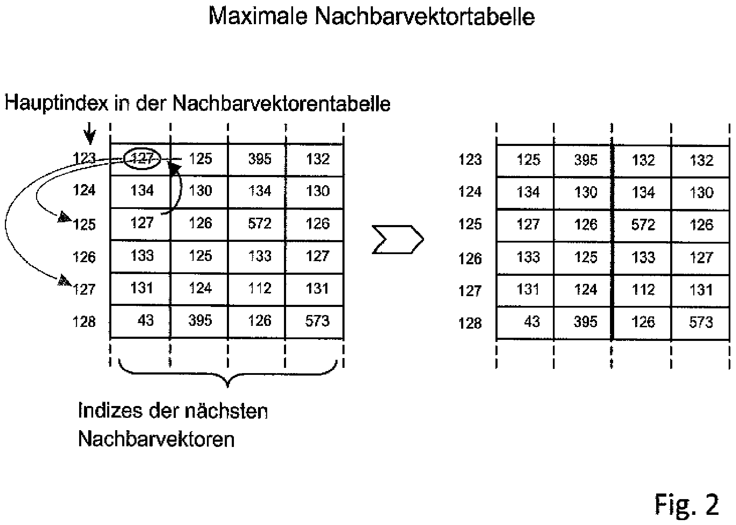

Entsprechend wird der erste Elternindex in der Nachbarvektorentabelle gelöscht, wenn auch nur einer der beiden Kinderindizes, die von dem zweiten Elternindex abgeleitet wurden, mit dem ersten Elternindex übereinstimmt. Beispielhaft kann dies anhand der FIG. 2 dargestellt werden, wenn beispielsweise der Hauptindex 123 betrachtet wird.

Die Elternindizes zu diesem Index 123 sind die Codebuchvektorindizes 127 und 125. Die Kinderindizes des ersten Elternindex sind die Indizes 131 und 124. Die des zweiten Elternindex sind die Indizes 127 und 126. In diesem Fall wird der erste Elternindex aus der Tabelle gestrichen, da er mit einem der Kinderindizes des zweiten Elternindex, nämlich dem Index 127, übereinstimmt.

Ein gestrichener, also gelöschter, Index wird vorzugsweise durch seinen nächsten benachbarten Codebuchvektorindex in der Nachbarvektortabelle ersetzt. Diese Prozedur wird vorzugsweise für alle Elemente der Nachbarvektorentabelle ausgeführt, wobei die Zahl der Streichungen von Einträgen vorzugsweise gezählt wird. Dieser Schritt wird anschließend wiederholt bis die Zahl der Streichungen, die gezählt wurde bei einem Durchgang durch die Nachbarvektorentabelle 0 ist, d. h. solange bis keine weiteren Streichungen auftreten.

Experimentelle Untersuchungen mit Sprachsignalen haben ergeben, dass das erfindungsgemäße Verfahren zu einer erheblichen Verbesserung der Genauigkeit bei der Sprachkodierung führen kann. Für unterschiedliche Werte der Größe NB_NN des Satzes der Nachbarvektoren zeigt die nachstehende Tabelle die jeweilige Abdeckung und die Komplexität der Suche nach der Erfindung im Vergleich zur Standard-Suche bzw. zur Vollsuche.

| Suchverfahren | Abdeckung | Komplexität | Zusätzliche Komplexität |
|---|---|---|---|
| Standard | 48.9% | 2.755 | |
| Vollsuche | 100.0% | 15.678 | |
| Erfindungsgemäße Suche mit NB_NN=4 | 67.3% | 3.289 | 0.534 |
| Erfindungsgemäße Suche mit NB_NN=6 | 70.1% | 3.405 | 0.650 |
| Erfindungsgemäße Suche mit NB_NN=8 | 72.0% | 3.543 | 0.788 |
| Erfindungsgemäße Suche mit NB_NN=10 | 72.8% | 3.690 | 0.935 |
| Erfindungsgemäße Suche mit NB_NN=12 | 73.5% | 3.839 | 1.084 |
| Erfindungsgemäße Suche mit NB_NN=14 | 73.7% | 3.977 | 1.222 |
| Erfindungsgemäße Suche mit NB_NN=16 | 74.1% | 4.155 | 1.400 |

**Patentansprüche**

1. Verfahren zur Vektor-Quantisierung eines Merkmalsvektors, verwendet im Zusammenhang mit einer Datenkompression eines zu übertragenden oder eines zu speichernden Signals, insbesondere eines Sprachsignals oder eines Videosignals, bei dem wenigstens ein Codebuch, welches eine Mehrzahl von Codebuchvektoren umfasst, nach einem den Merkmalsvektor repräsentierenden Codevektor durchsucht wird, indem während der Suche eine Folge von Codebuchvektoren auf ihre Eignung zur Repräsentation des Merkmalsvektors geprüft wird, wobei das Verfahren folgende Schritte umfasst:

a) zu wenigstens einem im Verlauf der Suche nach dem Codevektor möglicherweise zu prüfenden Codebuchvektor wird vor Beginn der Suche ein Satz von Nachbarvektoren bestimmt;
b) die Suche nach dem Codevektor wird wenigstens auf eine Teilmenge der Nachbarvektoren erstreckt, so dass eine erschöpfende Suche im Codebuch vermieden wird,

**dadurch gekennzeichnet, dass**

c) der Satz von Nachbarvektoren zu einem Codebuchvektor ermittelt wird mit Hilfe einer Nachbarvektortabelle, die jedem Codebuchvektor aus einer Mehrzahl von Codebuchvektoren des wenigstens einen Codebuchs eine Anzahl nächster Nachbarvektoren zuordnet, indem, ausgehend von dem Codebuchvektor, dessen Satz von Nachbarvektoren bestimmt werden soll, und welcher als Startvektor in den Satz der Nachbarvektoren eingetragen wird, die Folge der jeweils nächsten Nachbarvektoren eines jeden bereits vorhandenen Eintrags im Satz der Nachbarvektoren ihrerseits in den Satz der Nachbarvektoren eingetragen wird, solange, bis keine neuen Einträge mehr hinzukommen oder bis die Eintragung abgebrochen wird, weil die Zahl der Nachbarvektoren im Satz der Nachbarvektoren eine vorgegebene Grenze erreicht hat, und dass
d) die Nachbarvektortabelle zu dem Codebuchvektor ermittelt wird, indem zunächst zu wenigstens einer Teilmenge der Codebuchvektoren des wenigstens einen Codebuches eine Anzahl nächster Nachbarvektoren vorzugsweise durch Bestimmung der jeweiligen Abstände ermittelt wird, und indem die so gewonnene Nachbarvektortabelle durch eine Iteration folgender Schritte modifiziert wird:

d1) zu dem einem Codebuchvektor in der Nachbarvektortabelle werden dessen zwei nächste Nachbarvektoren ermittelt; sie bilden die Elternvektoren dieses Codebuchvektors;

d2) zu dem ersten Elternvektor werden die zwei nächsten Nachbarvektoren aus der Nachbarvektortabelle ermittelt; sie bilden die Kindervektoren des ersten Elternvektors;

d3) der zweite Elternvektor wird aus der Nachbarvektortabelle gestrichen und durch seinen nächsten Nachbarvektor in der Nachbarvektorentabelle ersetzt, falls einer der beiden Kindervektoren des ersten Elternvektors mit dem zweiten Elternvektor übereinstimmt;

d4) zu dem zweiten Elternvektor werden die zwei nächsten Nachbarvektoren aus der Nachbarvektortabelle ermittelt; sie bilden die Kindervektoren des zweiten Elternvektors;

d5) der erste Elternvektor wird aus der Nachbarvektortabelle gestrichen und durch seinen nächsten Nachbarvektor in der Nachbarvektorentabelle ersetzt, falls einer der beiden Kindervektoren des zweiten Elternvektors mit dem ersten Elternvektor übereinstimmt.

**2.** Verwendung eines Verfahrens nach Anspruch 1 zur Verringerung eines Maßes für den Kodierungsfehler im Zusammenhang mit einem Verfahren zur Sprachcodierung oder zur Videocodierung.

## Claims

**1.** A method for the vector quantization of a feature vector, used in conjunction with a data compression of a signal to be transmitted or to be stored, especially a language signal or a video signal in which at least one codebook which comprises a plurality of codebook vectors is searched for a code vector representing the feature vector in that during the search a sequence of codebook vectors is checked for their suitability to represent the feature vector, wherein the method comprises the following steps:

a) A set of adjacent vectors is determined prior to the beginning of the search for at least one codebook vector to be possibly checked in the course of the search for the code vector;

b) The search for the code vector is extended at least to a partial amount of the adjacent vectors so that an exhaustive search in the codebook is avoided,

**characterized in that**

c) The set of adjacent vectors is determined for a codebook vector with the aid of an adjacent vector table which associates a number of very close adjacent vectors with each codebook vector from a plurality of codebook vectors of the at least one codebook **in that**, starting from the codebook vector whose set of adjacent vectors is to be determined and which is registered as start vector in the set of adjacent vectors, the sequence of the particular very close adjacent vectors of each entry already present in the set of adjacent vectors is registered for its part in the set of adjacent vectors until no more new entries are added or until the registration is broken off because the number of adjacent vectors in the set of the adjacent vectors has reached a given limit, and that d) The adjacent vector table is determined for the codebook vector **in that** a number of very close adjacent vectors is preferably determined at first by determining the particular intervals for at least a partial amount of the codebook vectors of the at least one codebook, and **in that** the adjacent vector table obtained in this manner is modified by an iteration of the following steps:

d1) The two closest adjacent vectors are determined for the codebook vector in the adjacent vector table; they form the parent vectors of this codebook vector;

d2) The two closest adjacent vectors from the adjacent vector table are determined for the first parent vector; they form the children vectors of the first parent vector;

d3) The second parent vector is struck from the adjacent vector table and replaced by its closest adjacent vector in the adjacent vector table if one of the two children vectors of the first parent vector coincides with the second parent vector;

d4) The two closest adjacent vectors are determined from the adjacent vector table for the second parent vector; they form the children vectors of the second parent vector;

d5) The first parent vector is struck from the adjacent vector table and replaced by its closest adjacent vector in the adjacent vector table if one of the two children vectors of the second parent vector coincides with the first parent vector.

2. The use of a method according to Claim 1 to reduce a measure for the coding errors in conjunction with a method for language coding or for video coding.

**Revendications**

1. Procédé de quantification vectorielle d'un vecteur caractéristique, utilisé en relation avec une compression de données d'un signal à transmettre ou d'un signal à mémoriser, en particulier d'un signal vocal ou d'un signal vidéo, selon lequel au moins un livre de codes, qui comprend une pluralité de vecteurs de livre de codes, est parcouru pour rechercher un vecteur de code représentant le vecteur caractéristique par le fait que, durant la recherche, une série de vecteurs de livre de codes sont vérifiés quant à leur aptitude à représenter le vecteur caractéristique, dans lequel le procédé comporte les étapes suivantes :

   a) avant le début de la recherche, un ensemble de vecteurs voisins est défini pour au moins un vecteur de livre de codes à vérifier si possible au cours de la recherche du vecteur de code ;
   b) la recherche du vecteur de code est étendue au moins à un sous-ensemble des vecteurs voisins de sorte qu'une recherche exhaustive est évitée dans le livre de codes,

   **caractérisé en ce que**

   c) l'ensemble de vecteurs voisins est déterminé pour un vecteur de livre de codes à l'aide d'un tableau de vecteurs voisins qui, à chaque vecteur de livre de codes parmi une pluralité de vecteurs de livre de codes de l'au moins un livre de codes, associe une quantité de prochains vecteurs voisins par le fait que, à partir du vecteur de livre de codes, dont l'ensemble de vecteurs voisins doit être défini et qui est enregistré en tant que vecteur initial dans l'ensemble des vecteurs voisins, la série des prochains vecteurs voisins respectifs de chaque élément enregistré déjà présent dans l'ensemble des vecteurs voisins est enregistrée de son côté dans l'ensemble des vecteurs voisins jusqu'à ce qu'aucun nouvel élément enregistré n'arrive plus ou jusqu'à ce que l'enregistrement soit interrompu parce que le nombre des vecteurs voisins dans l'ensemble des vecteurs voisins a atteint une limite prédéfinie, et **en ce que**
   d) le tableau de vecteurs voisins est déterminé pour le vecteur de livre de codes, par le fait que d'abord pour au moins un sous-ensemble des vecteurs de livre de codes de l'au moins un livre de codes est déterminée une quantité de prochains vecteurs voisins de préférence par définition des écarts respectifs, et par le fait que le tableau de vecteurs voisins ainsi obtenu est modifié par une itération des étapes suivantes :

      d1) pour le vecteur de livre de codes dans le tableau de vecteurs voisins sont déterminés ses deux prochains vecteurs voisins ; ils forment les vecteurs parents de ce vecteur de livre de codes ;
      d2) pour le premier vecteur parent sont déterminés les deux prochains vecteurs voisins à partir du tableau de vecteurs voisins ; ils forment les vecteurs enfants du premier vecteur parent ;
      d3) le second vecteur parent est supprimé du tableau de vecteurs voisins et remplacé par son prochain vecteur voisin dans le tableau de vecteurs voisins, dans le cas où un des deux vecteurs enfants du premier vecteur parent coïncide avec le second vecteur parent ;
      d4) pour le second vecteur parent sont déterminés les deux prochains vecteurs voisins à partir du tableau de vecteurs voisins ; ils forment les vecteurs enfants du second vecteur parent ;
      d5) le premier vecteur parent est supprimé du tableau de vecteurs voisins et est remplacé par son prochain vecteur voisin dans le tableau de vecteurs voisins dans le cas où un des deux vecteurs enfants du second vecteur parent coïncide avec le premier vecteur parent.

2. Utilisation d'un procédé selon la revendication 1 pour réduire une cote pour l'erreur de codage en relation avec un procédé de codage vocal ou de codage vidéo.

Nachbarvektortabelle  Satz von Nachbarvektoren

Fig. 1

EP 2 449 682 B1

# Maximale Nachbarvektortabelle

Hauptindex in der Nachbarvektorentabelle

| 123 | 127 | 125 | 395 | 132 |
| 124 | 134 | 130 | 134 | 130 |
| 125 | 127 | 126 | 572 | 126 |
| 126 | 133 | 125 | 133 | 127 |
| 127 | 131 | 124 | 112 | 131 |
| 128 | 43 | 395 | 126 | 573 |

| 123 | 125 | 395 | 132 | 132 |
| 124 | 134 | 130 | 134 | 130 |
| 125 | 127 | 126 | 572 | 126 |
| 126 | 133 | 125 | 133 | 127 |
| 127 | 131 | 124 | 112 | 131 |
| 128 | 43 | 395 | 126 | 573 |

Indizes der nächsten
Nachbarvektoren

EP 2 449 682 B1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **Y. HIWASAKI.** *G.711.1: A Wideband Extension to ITU-T G.711*